# EUROPEAN PATENT APPLICATION

(11) **EP 4 089 727 A1**
(43) Date of publication of application: **16.11.2022**
(21) Application number: 21768396.0
(22) Date of filing: 10.03.2021
(51) Int. Cl.: H01L 23/62, H01L 23/528

(54) **SEMICONDUCTOR STRUCTURE AND FORMATION METHOD THEREFOR, AND FUSING METHOD FOR LASER FUSE**

(30) Priority: 13.03.2020 CN 202010174314
(71) Applicant: Changxin Memory Technologies, Inc., Hefei, Anhui 230601 (CN)
(72) Inventor: WU, Tong, Hefei, Anhui 230601 (CN); XU, Yachao, Hefei, Anhui 230601 (CN)
(74) Representative: Lavoix
(86) International application number: PCT/CN2021/079973
(87) International publication number: WO 2021/180122

(57) **Abstract**

The present invention provides a semiconductor structure and a forming method thereof, and a method for fusing a laser fuse. The semiconductor structure comprises: a semiconductor substrate; interlayer dielectric layers located above the semiconductor substrate and at least two metal interconnection layers located in the interlayer dielectric layers; a laser fuse located in any metal interconnection layer above the bottom metal interconnection layer and metal islands located in the metal interconnection layers below the laser fuse, the metal islands in different metal interconnection layers being connected through conductive contact holes to form two conductive paths, the laser fuse connecting the two conductive paths in series through the conductive contact holes; and, an alignment mark located in the same metal interconnection layer as the laser fuse, the alignment mark being used as a mark for laser alignment during fusing the laser fuse. Since the alignment mark is located in the same metal interconnection layer as the laser fuse, the laser alignment effect can be improved.

## Description

### CROSS-REFERENCE TO RELATED APPLICATIONS

The present application claims the priority to the Chinese patent application 202010174314.9, titled "SEMICONDUCTOR STRUCTURE AND FORMING METHOD THEREOF, AND METHOD FOR FUSING LASER FUSE", filed on March 13, 2020, which is incorporated herein by reference in its entirety.

### TECHNICAL FIELD

The present application relates to the technical field of semiconductors, in particular to a semiconductor structure and a forming method thereof, and a method for fusing a laser fuse.

### BACKGROUND OF THE PRESENT INVENTION

With the improvement of the semiconductor technology and the increasing complexity of integrated circuits, the number of devices in a chip is increasing. However, the failure of a single device, for example a transistor or storage unit, often leads to the functional failure of the whole integrated circuit.

For example, DRAM chips manufactured by semiconductor processes will inevitably produce defective storage units, and there are usually redundant storage units on the DRAM chips. Therefore, the DRAM chips can be repaired by permanently replacing defective storage units with redundant storage units. A common method is to form some fusible connecting lines (i.e., fuse structures) in the integrated circuits. After chips are produced, if some storage units or circuits have functional problems, the fuse structures related to deflective circuits can be selectively fused (or broken), and redundant storage units are activated to form new circuits for replacement, achieving the purpose of repair.

The laser fuse is a common fuse structure, which is fused by a laser beam so as to change the circuit structure. During fusing a fuse, it is required to accurately locate the fuse. There is an alignment mark on the chip, and the alignment mark is scanned by a laser device so that an indication of the position of the fuse is obtained from the chip.

However, in the prior art, the laser beam often has an alignment deviation, resulting in failed circuit repairing.

### SUMMARY OF THE PRESENT INVENTION

A technical problem to be solved by the present application is to provide a semiconductor structure and a forming method thereof, and a method for fusing a laser fuse, to reduce the laser alignment deviation during the laser fusing process.

In order to solve the problem mentioned above, the present invention provides a semiconductor structure, comprising: a semiconductor substrate; interlayer dielectric layers located above the semiconductor substrate and at least two metal interconnection layers located in the interlayer dielectric layers; a laser fuse, located in any metal interconnection layer above the bottom metal interconnection layer; metal islands, located in the metal interconnection layers below the laser fuse, the metal islands in different metal interconnection layers being connected through conductive contact holes to form two conductive paths, the laser fuse connecting the two conductive paths in series through the conductive contact holes; and an alignment mark located in a same metal interconnection layer as the laser fuse, the alignment mark being used as a mark for laser alignment during fusing the laser fuse.

Optionally, in a direction from the semiconductor substrate up to the laser fuse, in each conductive path, the critical dimensions of the cross-sections of the conductive contact holes and the metal islands in a direction parallel to the surface of the semiconductor substrate increase layer by layer.

Optionally, a projection of the conductive contact hole/ the metal island in any layer on the semiconductor substrate is located within a projection of the conductive contact hole/ the metal island in an upper layer on the semiconductor substrate.

Optionally, first block layer flush with the top surfaces of the metal islands are provided in the interlayer dielectric layers.

Optionally, second block layer located on the surfaces of the first block layer and surrounding the bottoms of the conductive contact holes are further provided in the interlayer dielectric layers.

Optionally, a protective layer is covered on the surfaces of the laser fuse and the alignment mark.

Optionally, the semiconductor structure further comprises: a top dielectric layer covering the interlayer dielectric layers, a fusing window located above the laser fuse and the alignment mark being formed in the top dielectric layer, a dielectric material with a partial thickness being provided between the bottom of the fusing window and the surfaces of the laser fuse and the alignment mark to serve as the protective layer on the surfaces of the laser fuse and the alignment mark.

Optionally, the protective layer comprises at least one of a silicon oxide layer, a silicon nitride layer or a silicon oxynitride layer.

Optionally, the protective layer has a thickness of 20 nm to 200 nm.

Optionally, the laser fuse is connected to a single metal island through one or more conductive contact holes.

The technical solutions of the present invention further provide a method for forming a semiconductor structure, comprising following steps: providing a semiconductor substrate; forming interlayer dielectric layers above the semiconductor substrate and at least two metal interconnection layers located in the interlayer dielectric layers, comprising: forming a laser fuse in any metal interconnection layer above a bottom metal interconnection layer and metal islands located in the metal interconnection layers below the laser fuse, the metal islands in different metal interconnection layers being connected through conductive contact holes to form two conductive paths, the laser fuse connecting the two conductive paths in series through the conductive contact holes; and, forming an alignment mark located in a same metal interconnection layer as the laser fuse, the alignment mark being used as a mark for laser alignment during fusing the laser fuse.

Optionally, in a direction from the semiconductor substrate up to the laser fuse, in each conductive path, the critical dimensions of the cross-sections of the conductive contact holes and the metal islands in a direction parallel to the surface of the semiconductor substrate increase layer by layer.

Optionally, a projection of the conductive contact hole/ the metal island in any layer on the semiconductor substrate is located within a projection of the conductive contact hole/ the metal island in an upper layer on the semiconductor substrate.

Optionally, first block layer flush with the top surfaces of the metal islands are provided in the interlayer dielectric layers to serve as etching stop layers for forming through vias of the conductive contact holes in an upper layer; and, second block layer located on the surface of the first block layer and surrounding the bottoms of the conductive contact holes are further provided in the interlayer dielectric layers.

Optionally, the method for forming a semiconductor structure further comprises following steps: forming a top dielectric layer covering the interlayer dielectric layers; and, etching the top dielectric layer to form a fusing window located above the laser fuse and the alignment mark, dielectric material with a partial thickness being provided between the bottom of the fusing window and the surfaces of the laser fuse and the alignment mark to serve as protective layer covering the surfaces of the laser fuse and the alignment mark.

Optionally, one or more conductive contact holes are formed between the laser fuse and a single metal island.

The technical solutions of the present application further provide a method for fusing a laser fuse in a semiconductor structure, the semiconductor structure being claimed above, wherein the method comprises following steps: aligning laser to a fusing position by using a alignment mark, and fusing the laser fuse by laser so as to disconnect two conductive paths, wherein, during fusing process, the laser fuse and metal islands and conductive contact holes in the conductive paths below the laser fuse are fused by laser.

In the semiconductor structure of the present application, since the alignment mark and the laser fuse are formed in the same metal interconnection layer, the fusing window used for laser fusing will not expose the alignment mark, so that the problems such as deformation caused by exposure of the alignment mark can be avoided, and the deviation of laser alignment can be avoided or reduced.

Further, in a direction from the semiconductor substrate up to the laser fuse, in each conductive path, the critical dimensions of the cross-sections of the conductive contact holes and the metal islands in a direction parallel to the surface of the semiconductor substrate increase layer by layer, so that a projection of the conductive contact hole/ the metal island in any layer on the semiconductor substrate is located within a projection of the conductive contact hole/ the metal island in an upper layer on the semiconductor substrate. The difficulty in laser alignment can be reduced during the fusing process, and no dielectric material is mingled with the metal layers during the fusing process. Accordingly, the required laser energy can be reduced, and the power consumption can be thus reduced.

### BRIEF DESCRIPTION OF THE DRAWINGS

In order to describe the technical solutions in the embodiments of the present application more clearly, the drawings to be used in the embodiments of the present application will be briefly described below. Apparently, the drawings to be used in the following description show only some embodiments of the present application. For a person of ordinary skill in the art, other drawings may be obtained according to these drawings, without paying any creative effort.
FIG. 1 is a schematic diagram of a laser fuse structure according to an embodiment of the present application;
FIGS. 2a to 2d are structure diagrams of a semiconductor structure according to an embodiment of the present application;
FIGS. 3a to 3c are structure diagrams of a semiconductor structure according to an embodiment of the present application; and
FIGS. 4a to 4b are structure diagrams of a semiconductor structure according to an embodiment of the present application.

### DETAILED DESCRIPTION OF THE PRESENT INVENTION

In order to make the objectives, technical means and effects of the present application clearer, the present application will be further described below in detail with reference to the drawings. It should be understood that the embodiments to be described herein are only some but not all of the embodiments of the present application, and are not intended to limit the present application. All other embodiments obtained on the basis of the embodiments in the present application by those skilled in the art without paying any creative effort shall fall into the protection scope of the present application.

As described in the background, a laser alignment deviation often occurs during fusing a laser fuse, resulting in a failure in fusing the fuse and thus causing failed circuit repairing. The inventor(s) has (have) found that the cause for laser alignment deviation is the alignment mark' failure in accurate marking due to its corrosion as it is exposed to air. This will be specifically explained below.

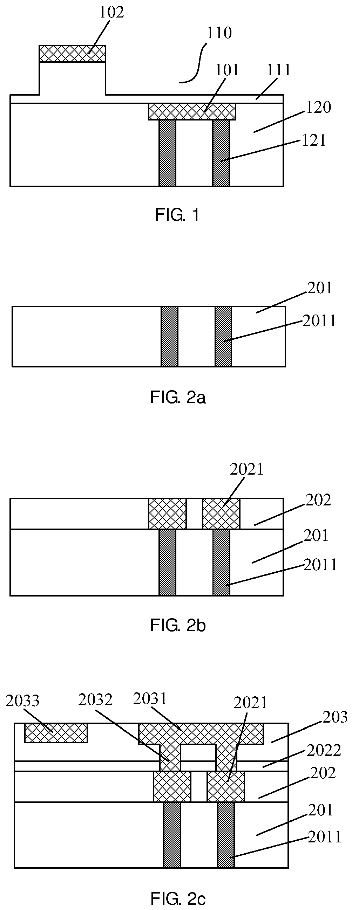

Referring to FIG. 1, FIG. 1 is a schematic diagram of a laser fuse structure according to an embodiment of the present application.

In this semiconductor structure, a laser fuse 101 is located in a first metal interconnection layer above a semiconductor substrate, and an alignment mark 102 is located in a second metal interconnection layer. The first metal interconnection layer is a bottom metal interconnection layer formed on the surface or inside of an interlayer dielectric layer 120 above the semiconductor substrate (not shown), and is directly connected to a semiconductor device formed in the semiconductor substrate through a conductive contact (CT) 121. The laser fuse is formed in the first interconnection layer, so the connecting line between the laser fuse 101 and the semiconductor device is shortest and the resistance is lower. The connecting circuits between different circuits can be significantly changed after fusing, so that better fusing and programming effects are achieved.

Since the line width in the first metal interconnection layer is usually required highly, the wiring density of metal lines is higher. Moreover, a better alignment effect can be achieved when the alignment mark for alignment is usually larger in size. Therefore, the alignment mark 102 is usually formed inside the second metal interconnection layer, or may be formed in a metal interconnection layer in a higher layer.

In order to fuse the laser fuse 101 by laser, a fusing window 110 needs to be formed on the surface of the laser fuse 101, the bottom of the fusing window 110 needs to stay above the metal fuse 101, and a protective layer 111 with a small thickness is reserved only above the metal fuse 101. During the formation of the fusing window 110, the surface of the alignment mark 102 in the second metal interconnection layer will be exposed. In the advanced semiconductor manufacturing technology, in order to reduce the resistance and improve the computing efficiency of the integrated circuit, the second metal interconnection layer and the metal interconnection layers above the second metal interconnection layer are all made of Cu. Since Cu is easily corroded when exposed to air, serious corrosion will lead to deformation or indistinctness of the pattern of the alignment mark 102, resulting in laser alignment deviation.

The inventor(s) proposes (propose) a new semiconductor structure and a forming method thereof, and a method for fusing a laser fuse, to solve the problem mentioned above. The embodiments of the present application will be described below in detail with reference to the drawings.

Referring to FIGS. 2a to 2d, sectional views of a formation process of a semiconductor structure according to an embodiment of the present application are shown. Specifically, only a single laser fuse structure in a laser fuse structure array is shown in the semiconductor structure.

Referring to FIG. 2a, a semiconductor substrate (not shown) is provided. A first dielectric layers 201 is formed on the surface of the semiconductor substrate, and conductive plugs 2011 connecting semiconductor devices in the semiconductor substrate are formed in the first dielectric layer 201. The conductive plugs 2011 may be made of metal materials such as tungsten, copper or silver.

Referring to FIG. 2b, a second dielectric layer 202 and metal islands 2021 located in the second dielectric layer 202 are formed above the first dielectric layer 201. The metal islands 2021 may be formed by a single Damascene process. Actually, in this step, a bottom metal interconnection layer is formed in the second dielectric layer 202. The bottom metal layer is used for realizing direct electrical connection to the devices in the semiconductor substrate through the conductive plugs 2011. The metal islands 2021 are part of the bottom metal layer. Metal interconnection lines or other structures are further formed at other positions on the second dielectric layer 202. The bottom metal layer may be formed by a single Damascene process, or the bottom metal interconnection layer may also be formed by forming a metal material layer covering the first dielectric layer 201 and then patterning the metal material layer. Then, a dielectric material is formed on the first dielectric layer 201 and then flattened to form a second dielectric layer 202 flush with the surfaces of the metal islands 2021. The cross-sections of the metal islands 2021 may be rectangular, circular, polygonal or in other planar shapes.

Referring to FIG. 2c, a block layer 2022 and a third dielectric layer 203 covering the block layer 2022 are formed on the surface of the second dielectric layer 202. Conductive contact holes 2032 and a laser fuse 2031 located on the conductive contact holes 2032 are formed in the third dielectric layer 203.

The bottoms of the conductive contact holes 2032 run through the block layer 2022 to be located on the surfaces of the metal islands 2021, so as to connect the metal islands 2021 with the laser fuse 2031. The laser fuse 2031 connects the two metal islands 2021 through the conductive contact holes 2032, so that two conductive paths where the two metal islands 2021 are located are connected. The two conductive paths can be disconnected by fusing the laser fuse 2031 by laser.

The laser fuse 2031 is located in the second metal interconnection layer above the bottom metal interconnection layer, and other metal interconnection lines may also be formed in the second metal interconnection layer. In this embodiment, an alignment mark 2033 is further formed in the second metal interconnection layer. The alignment mark 2033 is used for identifying the position of the laser fuse 2031 to realize alignment with the position of the laser fuse during the laser fusing process.

The laser fuse 2031 and the conductive contact holes 2031 may be formed by a dual Damascene process. Specifically, through vias and grooves located above the through vias are formed in the second dielectric layer 203, the through vias and the grooves are then filled, the conductive contact holes 2031 are formed within the through vias, and the laser fuse 2031 is formed within the grooves. The alignment mark may be formed by a single Damascene process.

The laser fuse 2031, the conductive contact holes 2032 and the alignment mark 2033 may be made of metal materials such as tungsten, copper or silver. Preferably, a metal block layer may also be formed between the laser fuse 2031, the conductive contact holes 2032 and the alignment mark 2033 and the second dielectric layer 203 to avoid diffusion of atoms in the metal material. The metal block layer may be made of at least one of TiN and TaN.

The conductive contact holes 2032 are located on the surfaces of the metal islands 2021, and have a cross-sectional dimension that is less than the surface dimension of the tops of the metal islands 2021. The block layer 2022 further covers part of the surfaces of the metal islands 2021, so that the material of the metal islands 2021 can be prevented from electromigration between contact surfaces of the metal islands 2021 and the second dielectric layer 203 or from diffusion into the second dielectric layer 203.

In some embodiments, the block layer 2022 may be made of SiN, SiON, SiCN or the like, and the first dielectric layer 201, the second dielectric layer 202 and the third dielectric layer 203 may be made of interlayer dielectric layer materials commonly used in the integrated circuit support, such as silicon oxide, silicon oxynitride or silicon carbonoxide, or may be made of low-k dielectric materials such as amorphous carbon or porous silicon oxide.

In this embodiment, the conductive contact holes 2032 and the conductive plugs 2011 are overlapped in a vertical direction. In the sectional view shown in FIG. 2c, the conductive contact holes 2032 and the conductive plugs 2011 are both shown, in order to clearly illustrate the conductive paths formed by the conductive contact holes 2032, the metal islands 2021 and the conductive plugs 2011. However, it is not limited that the conductive contact holes 2032 and the conductive plugs 2011 are overlapped in the vertical direction. In some embodiments, due to the limitation of the wiring rules, the conductive contact holes 2032 and the conductive plugs 2011 may be distributed in a staggered manner, so that the conductive contact holes 2032 and the conductive plugs 2011 cannot be shown in a same sectional view.

In the embodiment of the present application, the conductive contact holes are vertical interconnection structures connecting upper and lower metal interconnection layers, the conductive plugs are vertical interconnection structures connecting the first metal interconnection layer to the semiconductor substrate. The conductive contact holes and the conductive plugs are generally columnar. Although the conductive contact holes and the conductive plugs are named differently, the both refer to vertical interconnection structures.

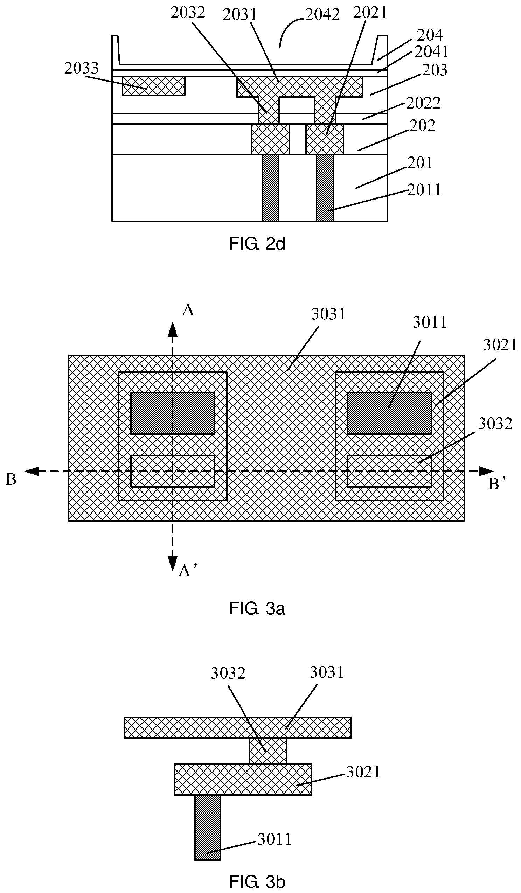

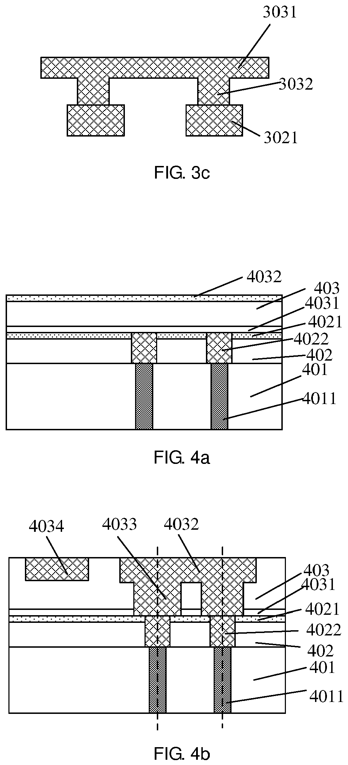

Referring to FIG. 3a, in another embodiment, a schematic diagram of the projection of each part in the laser fuse structure of the semiconductor structure on the surface of the semiconductor substrate is shown. Also referring to FIG. 3b, a sectional view of the laser fuse structure in the direction A-A' in FIG. 3a is shown. FIG. 3c is a sectional view of the laser fuse structure in the direction B-B' in FIG. 3a. In FIGS. 3a to 3c, only the laser fuse and the conductive paths connected by the laser fuse in the semiconductor structure are shown, with the interlayer dielectric layer surrounding the conductive paths being omitted.

The laser fuse structure comprises conductive plugs 3011, metal islands 3021, conductive contact holes 3032 and a laser fuse 3031. The conductive contact holes 3032 and the conductive plugs 3011 are staggered and not overlapped in the vertical direction.

Continuously referring to FIG. 2d, a block layer 2041 covering the second dielectric layer 203 and a fourth dielectric layer 204 located on the surface of the block layer 2041 are successively formed. The fourth dielectric layer 204 is etched to form a fusing window 2042 located above the laser fuse 2031 and the alignment mark 2033. A dielectric material with a partial thickness is provided between the bottom of the fusing window 2042 and the surfaces of the laser fuse 2031 and the alignment mark 2033 to serve as the protective layer covering the surfaces of the laser fuse 2031 and the alignment mark 2033. When it is unnecessary to fuse the laser fuse 2031, the protective layer can protect the laser fuse 2031 and the alignment mark 2033. When it is necessary to fuse the laser fuse 2031, the laser fuse 2031 is directly fused through the fusing window 2042.

The protective layer on the surface of the laser fuse 2031 is small in thickness, so that the protective layer is transparent, and the laser fuse 2031 can be aligned by using the alignment mark 2033 during laser fusing. Since the protective layer is covered on the surface of the alignment mark 2033, the alignment mark 2033 can be prevented from being oxidized or damaged to deform, and the deviation of the laser beam during laser fusing can be thus avoided.

In this embodiment, the protective laser comprises a block layer 2041 and a dielectric layer with a partial thickness that is located on the block layer 2041 and reserved after etching the fourth dielectric layer 204.

In other embodiments, during the formation of the fusing window 2042, the block layer 2041 can be used as an etching stop layer, so that only the block layer 2041 is covered on the laser fuse 2031 and the alignment mark 2033 to serve as a protective layer. In this embodiment, the time of stopping etching the fourth dielectric layer 204 is easily controlled, but the thickness of the protective layer only depends on the thickness of the block layer 2041. The block layer 2041 and the fourth dielectric layer 204 may be made of two different materials, so that the fourth dielectric layer 204 and the block layer 2041 have a higher etching selectivity during etching the dielectric layer 204. The block layer 2041 is further used to block the materials of the laser fuse 2031 and the alignment mark 2033 from diffusing into the fourth dielectric layer 204. In some embodiments, the block layer 2041 may be made of silicon nitride, silicon carbonitride or the like, and the fourth dielectric layer 204 may be made of an interlayer dielectric layer material commonly used in the integrated circuit support, such as silicon oxide, silicon oxynitride or silicon carbonoxide, or may be made of a low-k dielectric material such as amorphous carbon or porous silicon oxide.

In the embodiment, the first dielectric layer 201, the second dielectric layer 202, the third dielectric layer 203, the fourth dielectric layer 204 and the block layers 2041 and 2022 are used as interlayer dielectric layers above the semiconductor substrate or part of the interlayer dielectric layers, to isolate the metal layers and the interlayer interconnection structures.

In the embodiment of the present application, the laser fuse 2031 is connected to a single metal island 2021 through only one conductive contact hole 2032. In other embodiments, in a case where the laser fuse and the metal islands are large in area, the number of conductive contact holes may be increased, so that the laser fuse is connected to a single island through two or more conductive contact holes in order to reduce the connection resistance between the laser fuse and the metal island. After the laser fuse is fused, the resistance between two conductive paths changes more significantly. Similarly, a single metal island 2021 may also be connected to a device (devices) or a circuit (circuits) in the semiconductor substrate through two or more conductive plugs in order to reduce the connection resistance.

In the embodiment, the laser fuse is formed in the second metal interconnection layer above the semiconductor substrate, and the metal islands are formed in the first metal interconnection layer above the semiconductor substrate. However, in other embodiments, the laser fuse may be formed in the second layer above the semiconductor substrate or any metal layer above the second layer, metal islands are formed in multiple metal layers below the laser fuse layer, and upper and lower conductive paths connected in series are formed through conductive contact holes. The fusing window used for laser fusing will not expose the alignment mark as long as the alignment mark and the laser fuse are formed in a same metal layer, so that the problems such as deformation caused by exposure of the alignment mark can be avoided, and the deviation of laser alignment can be avoided or reduced.

During the laser fusing process, if only the laser fuse is fused, metal spattering generated during the fusing process or metal diffusion migration caused by high temperature might still cause a short circuit between two conductive paths connected by the laser fuse. Particularly, porous dielectric materials are more used as the material of the dielectric layer between metal layers. In order to completely disconnect the two conductive paths connected by the laser fuse, the whole conductive paths are usually fused vertically, and the meal on the conductive paths is melted by laser, so that the metal is completely vaporized and discharged at a high temperature. Although the problem of laser alignment deviation has been solved in the embodiment, by arranging the laser fuse in the first layer or a metal interconnection layer in upper layers, the distance between the laser fuse and the semiconductor substrate will be increased, the number of conductive contact holes and metal islands in the conductive paths connected by the laser fuse will be increased, and more energy will be consumed during laser fusing. Further, since the conductive contact holes and the conductive plugs are usually smaller than the metal islands in size, there is a dielectric layer between metal islands in the vertical laser fusing route, and the dielectric layer needs to consume more laser energy. In the semiconductor structure shown in FIG. 3b, in a case where there are position deviations between the conductive contact holes or between the conductive contact holes and the conductive plugs, the metal in the conductive paths cannot be completely fused by a single vertical laser fusing route, and it is necessary to adjust the position of the laser beam. Thus, more energy will be consumed during the whole laser fusing process, and the operation may be more complicated.

In order to further improve the problem mentioned above, the inventor(s) also provides (provide) a new semiconductor structure and a forming method thereof.

Referring to FIGS. 4a to 4b, sectional views of a formation process of a semiconductor structure according to another embodiment of the present application are shown.

Referring to FIG. 4a, a semiconductor substrate (not shown) is provided, and a first dielectric layer 401 is formed on the surface of the semiconductor substrate. A second dielectric layer 402, a first block layer 4021 covering the second dielectric layer 402 and metal islands 4022 located in the second dielectric layer 402 are formed on the first dielectric layer 401. The surfaces of the metal islands 4022 are flush with the surface of the first block layer 4021. Then, a second block layer 4031, a third dielectric layer 403 and a first block layer 4032 are successively formed on the first block layer 4021 and the surfaces of the metal islands 4022.

Conductive plugs 4011 connecting semiconductor devices in the semiconductor substrate are formed in the first dielectric layer 401. The conductive plugs 4011 may be made of metal materials such as tungsten, copper or silver. In this embodiment, by forming a laser fuse structure as an example, the first dielectric layer 401 is illustrated to be formed with two conductive plugs 4011, which are used to form two different conductive paths, respectively.

The metal islands 4022 may be formed by a single Damascene process, comprising: after the second dielectric layer 402 and the first block layer 4021 are formed, the first block layer 4021 and the second dielectric layer 402 are etched to form grooves, and metal material is filled in the grooves and flattened to form the metal islands 4022. Actually, in this step, a bottom metal interconnection layer is also formed in the second dielectric layer 402. The bottom metal layer is used for realizing direct electrical connection to the devices in the semiconductor substrate through the conductive plugs 4011. The metal islands 4022 are part of the bottom metal layer. Metal interconnection lines or other structures are further formed at other positions on the second dielectric layer 402.

The second block layer 4031 can block metal atoms in the metal islands 4022 from diffusing upward into the third dielectric layer 403. In other embodiments, it is also possible not to form the second block layer 4031.

In this embodiment, in a direction parallel to the surface of the semiconductor substrate, the cross-sectional dimension of the metal islands 4022 is greater than that of the conductive plugs 4011, so that projections of the conductive plugs 4011 on the surface of the semiconductor substrate are located within projections of the metal islands 4022 on the semiconductor substrate.

Referring to FIG. 4b, a second block layer 4031 and a third dielectric layer 403 are successively formed, which covering the first block layer 4021 and the surfaces of the metal islands 4022. Conductive contact holes 4033 and a laser fuse 4032 located above the conductive contact holes 4033 are formed in the third dielectric layer 403. Two ends of the laser fuse 4032 are connected to the conductive contact holes 4033, respectively, and then connected to the metal islands 4022 through the conductive contact holes 4033.

Specifically, the conductive contact holes 4033 and the laser fuse 4032 may be formed by a dual Damascene process. The cross-sectional dimension of the conductive contact holes 4033 is greater than that of the metal islands 4022, so that projections of the metal islands 4022 on the surface of the semiconductor substrate are located within projections of the conductive contact holes 4033 on the surface of the semiconductor substrate.

Since the dimension of the conductive contact holes 4033 is greater than that of the metal islands 4022, in the process of etching through vias used for forming the conductive contact holes 4033, the first block layer 4021 is used as an etching stop layer to timely stop the etching process and avoid over-etching of the second dielectric layer 402. The first block layer 4021 and the second block layer 4031 are arranged around the tops of the metal islands 4022 and the bottoms of the conductive contact hole 4033, respectively, thereby avoiding electromigration or diffusion of the metal islands 4022 and the conductive contact holes 4033 on the interfaces between the second dielectric layer 402 and the third dielectric layer 403.

The first block layers 4021 and 4032 and the second block layer 4031 are made of different materials, so that the second block layer 4031 and the first block layer 4021 have a higher etching selectivity. Preferably, the first block layer 4021 may be made of SiN, SiON, SiCN or the like, and the second block layer 4031 may be made of SiN, SiON, SiCN or the like.

The laser fuse 4033 is located in the second metal interconnection layer above the semiconductor substrate. In the embodiment of the present application, the formation process further comprises forming an alignment mark 4034 located in the same layer as the laser fuse 4033.

In other embodiments, the laser fuse may be located in a third layer or a metal connection layer in upper layers.

In a direction from the semiconductor substrate up to the laser fuse, the conductive connection structure in each conductive path comprises a conductive plug, a metal island and a conductive contact hole, and the critical dimension of the cross-section of each conductive connection structure in a direction parallel to the surface of the semiconductor substrate increases layer by layer, so that a projection of the conductive connection structure in a lower layer is located within a projection of the conduction connection structure in an upper layer. For example, in this embodiment, a projection of the conductive contact hole/metal island in any layer on the semiconductor substrate is located within a projection of the conductive contact hole/metal island in an upper layer on the semiconductor substrate. The critical dimension is the minimum feature size of the cross-section of the conductive connection structure. For example, when the cross-section of the conductive connection structure is circular, the critical dimension is the diameter of the cross-section; and, when the cross-section is rectangular, the critical dimension is the width of the shape. As shown in Fig 4b, from the bottom to the upper part, the cross-section dimensions of the conductive plugs 4011, the metal islands 4022 and the conductive contact portions 4033 gradually increase.

Subsequently, the formation process may further comprise forming a protective layer covering the laser fuse 4032, the alignment mark 4034 and the third dielectric layer 403. The method for forming the protective layer comprises: forming a top dielectric layer covering the third dielectric layer 403; etching the top dielectric layer to form a fusing window located above the laser fuse 4032 and the alignment mark 4034, and providing a dielectric material with a partial thickness between the bottom of the fusing window and the surfaces of the laser fuse 4032 and the alignment mark 4034 to serve as the protective layer covering the surfaces of the laser fuse 4032 and the alignment mark 4034.

In the embodiment, since the dimensions of the conductive connection structures, e.g., the conductive plugs, the metal islands and the conductive contact holes, in the conductive paths gradually increase from the bottom to the upper part, the conductive connection structures in the conductive paths are overlapped with each other and are all made of metal materials in the vertical direction. The difficulty in laser alignment can be reduced during the fusing process, and no dielectric material is mingled with the metal layers during the fusing process. Accordingly, the required laser energy can be reduced, and the power consumption can be thus reduced.

An embodiment of the present application further provides a semiconductor structure, comprising: a semiconductor substrate; interlayer dielectric layers located above the semiconductor substrate and at least two metal interconnection layers located in the interlayer dielectric layers; a laser fuse located in any metal interconnection layer above the bottom metal interconnection layer, and metal islands located in the metal interconnection layers below the laser fuse, the metal islands in different metal interconnection layers being connected through conductive contact holes to form two conductive paths, the laser fuse connecting the two conductive paths in series through the conductive contact holes; and, an alignment mark located in a same metal interconnection layer as the laser fuse, the alignment mark being used as a mark for laser alignment during fusing the laser fuse.

Since the alignment mark is located in the same metal interconnection layer as the laser fuse, the protective layer formed on the bottom of the fusing window and above the laser fuse and the alignment mark can cover both the laser fuse and the alignment mark, thus preventing the alignment mark from being oxidized or damaged due to exposure.

Referring to FIG. 2d, a sectional view of a semiconductor structure according to an embodiment of the present application is shown.

In this embodiment, the semiconductor structure comprises: a semiconductor substrate (not shown); a first dielectric layer 201 formed on the surface of the semiconductor substrate, conductive plugs 2011 connecting semiconductor devices in the semiconductor substrate being formed in the first dielectric layer 201; a second dielectric layer 202 formed on the first dielectric layer 201 and metal islands 2021 located in the second dielectric layer 202, the metal islands 2021 being connected to the conductive plugs 2011; a block layer 2022 and a third dielectric layer 203 covering the block layer 2022, which are formed on the surface of the second dielectric layer 202; conductive contact holes 2032 formed in the third dielectric layer 203 and a laser fuse 2031 located above the conductive contact holes 2032, the bottoms of the conductive contact holes 2032 running through the block layer 2022 to be located on the surfaces of the metal islands 2021, so as to connect the metal islands 2021 with the laser fuse 2031, the laser fuse 2031 connecting the two metal islands 2021 through the conductive contact holes 2032, so that two conductive paths where the two metal islands 2021 are located are connected; a block layer 2041 covering the surface of the second dielectric layer 203 and a fourth dielectric layer 204 located on the surface of the block layer 2041; and, a fusing window 2042 located above the laser fuse 2031 and the alignment mark 2033, a dielectric material with a partial thickness being provided between the bottom of the fusing window 2042 and the surfaces of the laser fuse 2031 and the alignment mark 2033 to serve as the protective layer covering the surfaces of the laser fuse 2031 and the alignment mark 2033. When it is unnecessary to fuse the laser fuse 2031, the protective layer can protect the laser fuse 2031 and the alignment mark 2033. When it is necessary to fuse the laser fuse 2031, the laser fuse 2031 is directly fused through the fusing window 2042.

In this embodiment, the metal islands 2021 are located in a bottom metal interconnection layer on the surface of the semiconductor substrate, and the laser fuse 2031 and the alignment mark 2033 are located in a second metal interconnection layer above the bottom metal interconnection layer.

In other embodiments, the laser fuse may also be formed in a third layer or any metal interconnection layer above the third layer, and the lower portion of the laser fuse is connected to a device (devices) or a circuit (circuits) in the semiconductor substrate through a plurality of metal islands and conductive contact portions between layers.

In the embodiment shown in FIG. 2d, the conductive plugs 2011 and the conductive contact holes 2032 are overlapped in a direction perpendicular to the surface of the semiconductor substrate. In other embodiments, the conductive plugs and the conductive contact holes above the conductive plugs or the conductive contact portions in different layers may also be distributed in a staggered manner in the vertical direction. Referring to FIG. 3b, the conductive plugs 3011 and the conductive contact holes 2032 are staggered with each other in the vertical direction.

Continuously referring to FIG. 2d, the protective layer on the bottom of the fusing window 2042 may comprise at least one of a silicon oxide layer, a silicon nitride layer or a silicon oxynitride layer. The protective layer may have a thickness of 20 nm to 200 nm.

In the embodiment, the laser fuse 2031 is connected to a single metal island 2021 through only one conductive contact hole 2032. In other embodiments, in a case where the laser fuse and the metal islands are large in area, the number of conductive contact holes may be increased, so that the laser fuse is connected to a single island through two or more conductive contact holes, in order to reduce the connection resistance between the laser fuse and the metal island. After the laser fuse is fused, the resistance between two conductive paths changes more significantly. Similarly, a single metal island 2021 may also be connected to a device (devices) or a circuit (circuit) in the semiconductor substrate through two or more conductive plugs in order to reduce the connection resistance.

Referring to FIG. 4b, a schematic diagram of a semiconductor structure according to another embodiment of the present application is shown.

In this embodiment, the semiconductor structure comprises: a semiconductor substrate (not shown); a first dielectric layer 401 formed on the surface of the semiconductor substrate; a second dielectric layer 402 formed on the first dielectric layer 401, a first block layer 4021 covering the second dielectric layer 402, and metal islands 4022 located in the second dielectric layer 402, the surfaces of the metal islands 4022 being flush with the surface of the first block layer 4021; a second block layer 4031 covering the first block layer 4021 and the surfaces of the metal islands 4022, a third dielectric layer 403 located on the surface of the second block layer 4031, and a first block layer 4032 located on the surface of the third dielectric layer 403; a second block layer 4031 covering the first block layer 4021 and the surfaces of the metal islands 4022, and a third dielectric layer 403 located on the surface of the second block layer 4031; and, conductive contact holes 4033 located in the third dielectric layer 403, and a laser fuse 4032 located above the conductive contact holes 4033. Two ends of the laser fuse 4032 are connected to the conductive contact holes 4033, respectively, and then connected to the metal islands 4022 through the conductive contact holes 4033.

Conductive plugs 4011 connecting semiconductor devices in the semiconductor substrate are formed in the first dielectric layer 401. The conductive plugs 4011 may be made of metal materials such as tungsten, copper or silver. In this embodiment, by forming a laser fuse structure as an example, the first dielectric layer 401 is illustrated to be formed with two conductive plugs 4011, which are used to form two different conductive paths, respectively.

The metal islands 4022 are located in a bottom metal layer, which is used for realizing direct electrical connection to devices in the semiconductor substrate through the conductive plugs 4011. The metal islands 4022 are part of the bottom metal layer. Metal interconnection lines or other structures are formed at other positions of the second dielectric layer 402.

The second block layer 4031 can block metal atoms in the metal islands 4022 from diffusing upward into the third dielectric layer 403. In other embodiments, it is also possible not to form the second block layer 4031.

In this embodiment, in a direction parallel to the surface of the semiconductor substrate, the cross-sectional dimension of the metal islands 4022 is greater than that of the conductive plugs 4011, so that projections of the conductive plugs 4011 on the surface of the semiconductor substrate are located within projections of the metal islands 4022 on the semiconductor substrate.

The cross-sectional dimension of the conductive contact holes 4033 is greater than that of the metal islands 4022, so that projections of the metal islands 4022 on the surface of the semiconductor substrate are located within projections of the conductive contact holes 4033 on the surface of the semiconductor substrate.

Since the dimension of the conductive contact holes 4033 is greater than that of the metal islands 4022, in the process of etching through vias used for forming the conductive contact holes 4033, the first block layer 4021 is used as an etching stop layer to timely stop the etching process and avoid over-etching of the second dielectric layer 402. The first block layer 4021 and the second block layer 4031 are arranged around the tops of the metal islands 4022 and the bottoms of the conductive contact hole 4033, respectively, thereby avoiding electromigration or diffusion of the metal islands 4022 and the conductive contact holes 4033 on the interfaces between the second dielectric layer 402 and the third dielectric layer 403.

The laser fuse 4033 is located in a second metal interconnection layer above the semiconductor substrate, and the alignment mark 4034 is located in the same metal interconnection layer as the laser fuse 4033.

In other embodiments, the laser fuse and the alignment mark may be located in a third layer or a metal connection layer in upper layers.

In a direction from the semiconductor substrate up to the laser fuse, in each conductive path, the critical dimensions of the cross-sections of the conductive contact holes and the metal islands in a direction parallel to the surface of the semiconductor substrate increase layer by layer, so that a projection of the conductive contact hole/metal island in any layer on the semiconductor substrate is located within a projection of the conductive contact hole/metal island in an upper layer on the semiconductor substrate.

The semiconductor structure may further comprise a protective layer covering the laser fuse 4032, the alignment mark 4034 and the third dielectric layer 403. A fusing window is provided above the protective layer.

Since the dimensions of the conductive connection structures, e.g., the conductive plugs, the metal islands and the conductive contact holes, in the conductive paths of the semiconductor structure gradually increase from the bottom to upper part, the conductive connection structures in the conductive paths are overlapped with each other and are all made of metal materials in the vertical direction. The difficulty in laser alignment can be reduced during the fusing process, and no dielectric material is mingled with the metal layers in the fusing route (indicated by the dashed line in FIG. 4b). Accordingly, the required laser energy can be reduced, and the power consumption can be thus reduced.

An embodiment of the present application further provides a method for fusing a laser fuse in a semiconductor structure, specifically comprising following steps: aligning laser with a fusing position by using an alignment mark that is located in a same metal interconnection layer as the laser fuse, and fusing the laser fuse by laser so as to disconnect the two conductive paths, wherein, during the fusing process, the laser fuse and the metal islands and conductive contact holes in the two conductive paths below the laser fuse are fused by laser. Thus, the metal in the conductive paths is completely vaporized and discharged at a high temperature, and the fusing effect is improved.

During the fusing process, the laser beam can always be aligned with the metal in the conductive paths by adjusting the position of the laser beam. In the structure shown in FIG. 4b, since the conductive connection structures in the conductive paths are overlapped with each other and are all made of metal materials in the vertical direction, the difficulty in laser alignment can be reduced. During fusing in a direction indicated by the dashed line in FIG. 4b, the metal in the whole conductive paths can be fused by hardly or slightly moving the laser beam. Moreover, since no dielectric material is mingled in the on/off route, the required laser energy can be reduced, and the power consumption can be thus reduced.

The above description merely shows the preferred implementations of the present application. It should be noted that, for a person of ordinary skill in the art, various improvements and modifications may be made without departing from the principle of the present application, and those improvements and modifications shall also be regarded as falling into the protection scope of the present application.

## Claims

1. A semiconductor structure, comprising:
a semiconductor substrate;
interlayer dielectric layers located above the semiconductor substrate and at least two metal interconnection layers located in the interlayer dielectric layers;
a laser fuse, located in any metal interconnection layer above the bottom metal interconnection layer;
metal islands, located in the metal interconnection layers below the laser fuse, the metal islands in different metal interconnection layers being connected through conductive contact holes to form two conductive paths, the laser fuse connecting the two conductive paths in series through the conductive contact holes; and
an alignment mark located in a same metal interconnection layer as the laser fuse, the alignment mark being used as a mark for laser alignment during fusing the laser fuse.

2. The semiconductor structure according to claim 1, wherein, in a direction from the semiconductor substrate up to the laser fuse, in each conductive path, the critical dimensions of the cross-sections of the conductive contact holes and the metal islands in a direction parallel to the surface of the semiconductor substrate increase layer by layer.

3. The semiconductor structure according to claim 1, wherein a projection of the conductive contact hole/ the metal island in any layer on the semiconductor substrate is located within a projection of the conductive contact hole/ the metal island in an upper layer on the semiconductor substrate.

4. The semiconductor structure according to claim 1, wherein first block layer flush with the top surfaces of the metal islands are provided in the interlayer dielectric layers.

5. The semiconductor structure according to claim 4, wherein second block layer located on the surfaces of the first block layer and surrounding the bottoms of the conductive contact holes are further provided in the interlayer dielectric layers.

6. The semiconductor structure according to claim 1, wherein a protective layer is covered on the surfaces of the laser fuse and the alignment mark.

7. The semiconductor structure according to claim 6, further comprising: a top dielectric layer covering the interlayer dielectric layers, a fusing window located above the laser fuse and the alignment mark being formed in the top dielectric layer, a dielectric material with a partial thickness being provided between the bottom of the fusing window and the surfaces of the laser fuse and the alignment mark to serve as the protective layer on the surfaces of the laser fuse and the alignment mark.

8. The semiconductor structure according to claim 6, wherein the protective layer comprises at least one of a silicon oxide layer, a silicon nitride layer or a silicon oxynitride layer.

9. The semiconductor structure according to claim 6, wherein the protective layer has a thickness of 20 nm to 200 nm.

10. The semiconductor structure according to claim 1, wherein the laser fuse is connected to a single metal island through one or more conductive contact holes.

11. A method for forming a semiconductor structure, comprising following steps:
providing a semiconductor substrate;
forming interlayer dielectric layers above the semiconductor substrate and at least two metal interconnection layers located in the interlayer dielectric layers, comprising:
forming a laser fuse in any metal interconnection layer above a bottom metal interconnection layer and metal islands located in the metal interconnection layers below the laser fuse, the metal islands in different metal interconnection layers being connected through conductive contact holes to form two conductive paths, the laser fuse connecting the two conductive paths in series through the conductive contact holes; and
forming an alignment mark located in a same metal interconnection layer as the laser fuse, the alignment mark being used as a mark for laser alignment during fusing the laser fuse.

12. The method for forming a semiconductor structure according to claim 11, wherein, in a direction from the semiconductor substrate up to the laser fuse, in each conductive path, the critical dimensions of the cross-sections of the conductive contact holes and the metal islands in a direction parallel to the surface of the semiconductor substrate increase layer by layer.

13. The method for forming a semiconductor structure according to claim 12, wherein a projection of the conductive contact hole/ the metal island in any layer on the semiconductor substrate is located within a projection of the conductive contact hole/ the metal island in an upper layer on the semiconductor substrate.

14. The method for forming a semiconductor structure according to claim 11, wherein first block layer flush with the top surfaces of the metal islands are provided in the interlayer dielectric layers to serve as etching stop layers for forming through vias of the conductive contact holes in an upper layer; and, second block layer located on the surface of the first block layer and surrounding the bottoms of the conductive contact holes are further provided in the interlayer dielectric layers.

15. The method for forming a semiconductor structure according to claim 11, further comprising following steps: forming a top dielectric layer covering the interlayer dielectric layers; and, etching the top dielectric layer to form a fusing window located above the laser fuse and the alignment mark, dielectric material with a partial thickness being provided between the bottom of the fusing window and the surfaces of the laser fuse and the alignment mark to serve as protective layer covering the surfaces of the laser fuse and the alignment mark.

16. The method for forming a semiconductor structure according to claim 11, wherein one or more conductive contact holes are formed between the laser fuse and a single metal island.

17. A method for fusing a laser fuse in a semiconductor structure, the semiconductor structure being claimed in claim 1, wherein the method comprises following steps:
aligning laser to a fusing position by using an alignment mark, and fusing the laser fuse by laser so as to disconnect two conductive paths, wherein, during fusing process, the laser fuse and metal islands and conductive contact holes in the conductive paths below the laser fuse are fused by laser.
